# EUROPEAN PATENT APPLICATION

(11) **EP 4 668 332 A1**
(43) Date of publication of application: **24.12.2025**
(21) Application number: 25168539.2
(22) Date of filing: 04.04.2025
(51) Int. Cl.: H01L 23/528, H01L 21/768, H10D 88/00, H10D 84/01, H10D 30/47, H01L 21/283, H01L 23/48

(54) **SEMICONDUCTOR DEVICE AND METHOD FOR MANUFACTURING THE SAME**

(30) Priority: 21.06.2024 KR 20240081013
(71) Applicant: Samsung Electronics Co., Ltd., Suwon-si, Gyeonggi-do 16677 (KR)
(72) Inventor: LEE, Jung Han, 16677 Suwon-si (KR); PARK, Ji Soo, 16677 Suwon-si (KR); KIM, Byung-Sung, 16677 Suwon-si (KR); CHUN, Kwan Young, 16677 Suwon-si (KR)
(74) Representative: Marks & Clerk LLP

(57) **Abstract**

A semiconductor device including a stacked multi-gate transistor includes a substrate, a first active pattern including a first lower active pattern and a first upper active pattern, a second active pattern including a second lower active pattern and a second upper active pattern, a first gate structure, a second gate structure on the second active pattern, the first gate structure and the second gate structure are aligned, a cutting structure between the first active pattern and the second active pattern, the cutting structure separating the first gate structure and the second gate structure, a front wiring pattern that extends on an upper surface of the cutting structure, a first back wiring pattern, and a first through-via that extends into the substrate and the cutting structure, the first through-via electrically connects the front wiring pattern and the first back wiring pattern.

## Description

### BACKGROUND

The present disclosure relates to a semiconductor device and a method for manufacturing the same. More specifically, the present disclosure relates to a semiconductor device including a stacked multi-gate transistor and a method for manufacturing the same.

One of the scaling schemes for increasing an integration density of an integrated circuit device includes a multi-gate transistor in which a fin-shaped or nanowire-shaped silicon body is formed on a substrate and a gate is formed on a surface of the silicon body.

Because such a multi-gate transistor uses a three-dimensional channel, it is easy to scale the same. Further, current control capability of the multi-gate transistor may be improved without increasing a gate length of the multi-gate transistor. In addition, the multi-gate transistor may effectively suppress SCE (short channel effect) in which potential of a channel area is affected by drain voltage.

### SUMMARY

A technical purpose to be achieved by the present disclosure is to provide a semiconductor device having improved integration density and performance.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using concepts shown in the claims and combinations thereof.

According to some embodiments of the present inventive concept, there is provided a semiconductor device comprising a substrate including a first surface and a second surface opposite to each other, a first active pattern including a first lower active pattern and a first upper active pattern on the first surface, the first lower active pattern and the first upper active pattern extend in a first direction, a second active pattern including a second lower active pattern and a second upper active pattern on the first surface, the second lower active pattern and the second upper active pattern extend in the first direction, a first gate structure that extends in a second direction that intersects the first direction on the first active pattern, a second gate structure that extends in the second direction on the second active pattern, the first gate structure and the second gate structure are aligned along the second direction, a cutting structure between the first active pattern and the second active pattern, the cutting structure extends in the first direction and separates the first gate structure and the second gate structure, a front wiring pattern that extends in the first direction on an upper surface of the cutting structure, a first back wiring pattern that extends in the first direction on the second surface, and a first through-via that extends into the substrate and into the cutting structure, the first through-via electrically connects the front wiring pattern and the first back wiring pattern.

According to some embodiments of the present inventive concept, there is provided a semiconductor device comprising a substrate including a first surface and a second surface opposite to each other, a lower active pattern that extends in a first direction on the first surface, an upper active pattern that extends in the first direction on the first surface, the upper active pattern is a first distance from the first surface that is greater than a second distance from the lower active pattern to the first surface, a gate structure on the lower active pattern and the upper active pattern, the gate structure extends in a second direction that intersects the first direction, a first cutting structure spaced apart from the lower active pattern and the upper active pattern in the second direction, the first cutting structure extends in the first direction and intersects the gate structure, a first front wiring pattern that extends in the first direction on an upper surface of the first cutting structure, a first upper connection contact on a side surface of the gate structure, the first upper connection contact is electrically connected to an upper source/drain area of the upper active pattern, a first back wiring pattern that extends in the first direction on the second surface, a first lower connection contact on a side surface of the gate structure, the first lower connection contact electrically connected to a lower source/drain area of the lower active pattern, a first through-via that extends into the substrate and into the first cutting structure, the first through-via electrically connects the first front wiring pattern and the first back wiring pattern, and a second through-via that extends into the substrate and into the first cutting structure, the second through-via electrically connects the first upper connection contact and the first lower connection contact, and the first through-via and the second through-via are aligned along the first direction.

According to some embodiments of the present inventive concept, there is provided a semiconductor device which includes a first cell area, a second cell area, and a third cell area, the first cell area and the second cell area being along a first direction, the first cell area and the third cell area being along a second direction that intersects the first direction, the semiconductor device comprising a substrate including a first surface and a second surface opposite to each other, a front wiring pattern that extends in the first direction on the first surface, a first back wiring pattern that extends in the first direction on the second surface, a first through-via that extends into the substrate between the first cell area and the third cell area, the first through-via electrically connects the front wiring pattern and the first back wiring pattern, and a second through-via aligned with the first through-via along the first direction, wherein each of the first, second, and third cell areas includes a lower active pattern and an upper active pattern on the first surface and extend in the first direction, and a gate structure that extends in the second direction on the lower active pattern and the upper active pattern, wherein the second through-via electrically connects the lower active pattern of the second cell area and the upper active pattern of the second cell area.

At least some of the above and other features of the invention are set out in the claims.

### BRIEF DESCRIPTION OF DRAWINGS

The above and other aspects and features of the present disclosure will become more apparent by describing in detail illustrative embodiments thereof with reference to the attached drawings, in which:
FIG. 1 is a schematic layout diagram for illustrating a semiconductor device according to some embodiments.
FIG. 2 is an example layout diagram for illustrating the R area in FIG. 1.
FIG. 3 is a cross-sectional view cut along A-A in FIG. 2.
FIG. 4 is a cross-sectional view cut along B-B in FIG. 2.
FIG. 5 is a cross-sectional view cut along C-C in FIG. 2.
FIG. 6 is a cross-sectional view cut along D-D in FIG. 2.
FIG. 7 is a cross-sectional view cut along E-E in FIG. 2.
FIG. 8 is a cross-sectional view for illustrating a semiconductor device according to some embodiments.
FIG. 9 is a cross-sectional view for illustrating a semiconductor device according to some embodiments.
FIG. 10 is an example layout diagram for illustrating a semiconductor device according to some embodiments.
FIG. 11 is a cross-sectional view cut along F-F in FIG. 10.
FIG. 12 is an example layout diagram for illustrating a semiconductor device according to some embodiments.
FIG. 13 is a cross-sectional view cut along G-G in FIG. 12.
FIG. 14 is an example layout diagram for illustrating a semiconductor device according to some embodiments.
FIG. 15 is a cross-sectional view cut along H-H in FIG. 14.
FIG. 16 to FIG. 18 are various schematic layout diagrams for illustrating a semiconductor device according to some embodiments.

### DETAILED DESCRIPTIONS

It will be understood that, although the terms first, second, etc. may be used herein to describe various elements, these elements should not be limited by these terms. These terms are only used to distinguish one element from another element. Thus, for example, a first element, a first component or a first section discussed below could be termed a second element, a second component or a second section without departing from the teachings of the present inventive concept.

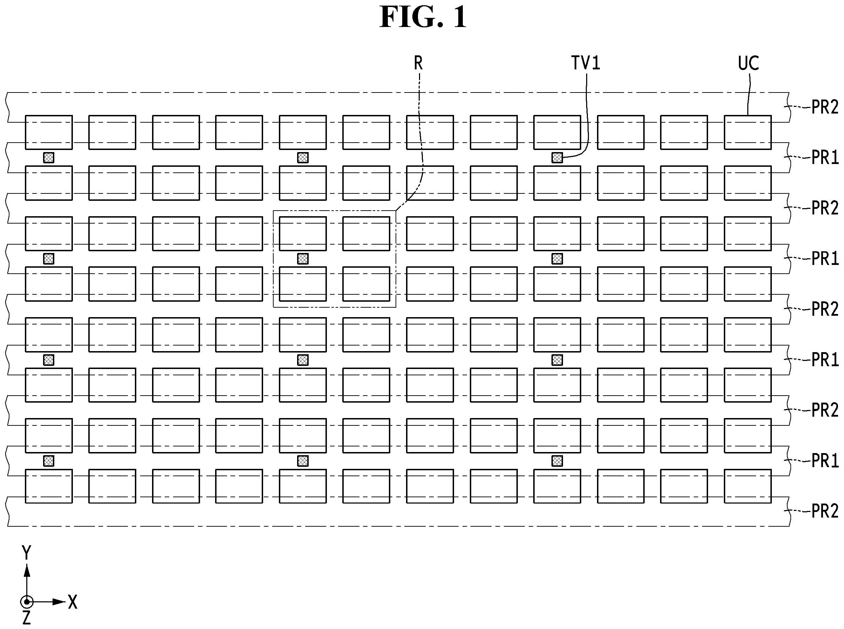

Hereinafter, with reference to FIGS. 1 to FIG. 18, a semiconductor device according to some embodiments is described.

FIG. 1 is a schematic layout diagram for illustrating a semiconductor device according to some embodiments.

Referring to FIG. 1, a semiconductor device according to some embodiments includes a plurality of unit cell areas UC, a first power wiring PR1, a second power wiring PR2, and a first through-via TV1.

The plurality of unit cell areas UC may be arranged two-dimensionally. For example, the plurality of unit cell areas UC may be arranged in a matrix form along a first direction X and a second direction Y that intersect each other. Each unit cell area UC may include various logic elements such as an inverter, an AND gate, an OR gate, a NAND gate, a NOR gate, an XOR gate, and/or a static random access memory (SRAM) element. etc. However, embodiments of the present disclosure are not limited thereto.

Each of the first power wiring PR1 and the second power wiring PR2 may extend in an elongated manner in the first direction X. The first power wirings PR1 and the second power wirings PR2 may be alternately arranged with each other along the second direction Y. Different power voltages may be respectively applied to the first power wiring PR1 and the second power wiring PR2. For example, a first power voltage (e.g., V_{SS}) may be applied to the first power wiring PR1, and a second power voltage (e.g., V_{DD}) different from the first power voltage may be applied to the second power wiring PR2. The first power wiring PR1 may provide the first power voltage to each unit cell area UC. The second power wiring PR2 may provide the second power voltage to each unit cell area UC.

The first through-via TV1 may be interposed between two unit cell areas UC adjacent to each other in the second direction Y. The first through-via TV1 may be connected to the first power wiring PR1. For example, the first through-via TV1 may overlap the first power wiring PR1 in a third direction Z that intersects the first direction X and the second direction Y. As used herein, "an element A overlaps an element B in a first direction" (or similar language) means that there is at least one straight line that extends in the first direction and intersects both the elements A and B.

One first power wiring PR1 may be commonly connected to a plurality of first through-vias TV1 arranged along the first direction X. The plurality of first through-vias TV1 arranged along the first direction X may be spaced apart from each other by a predetermined spacing. For example, within an area between two first through-vias TV1 adjacent to each other in the first direction X, a plurality of unit cell areas UC arranged along the first direction X may be disposed.

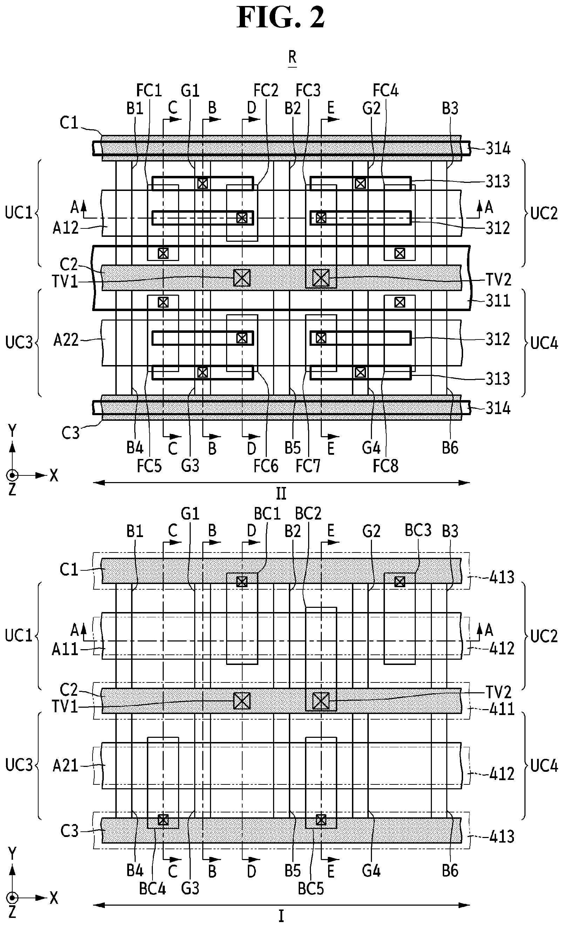

In some embodiments, a spacing between the first through-vias TV1 in the first direction X may be about 3 gate pitches or greater. For example, the spacing between the first through-vias TV1 in the first direction X may be in a range from about 3 gate pitches to about 100 gate pitches. In some embodiments, for example, the spacing between the first through-vias TV1 in the first direction X may be in a range from about 5 gate pitches to about 60 gate pitches. The first through-via TV1 is described in more detail later in the description of FIG. 2 to FIG. 7.

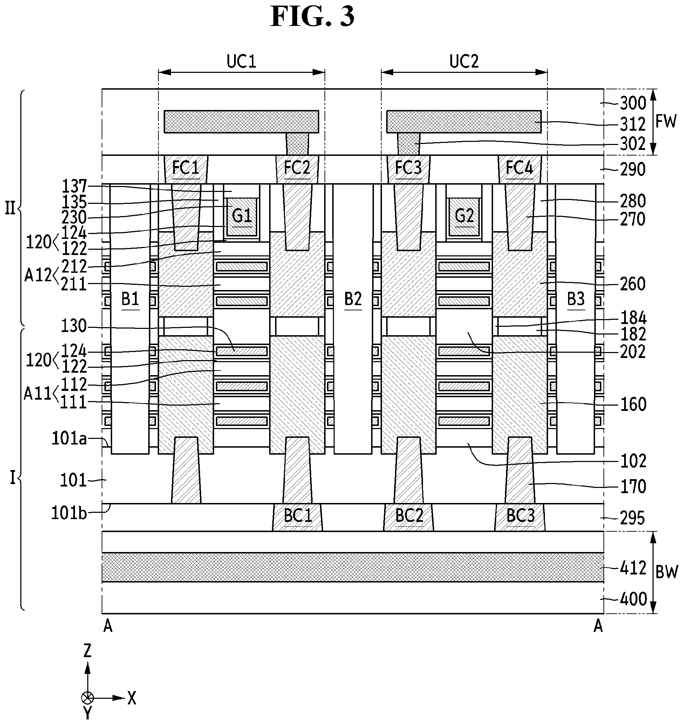

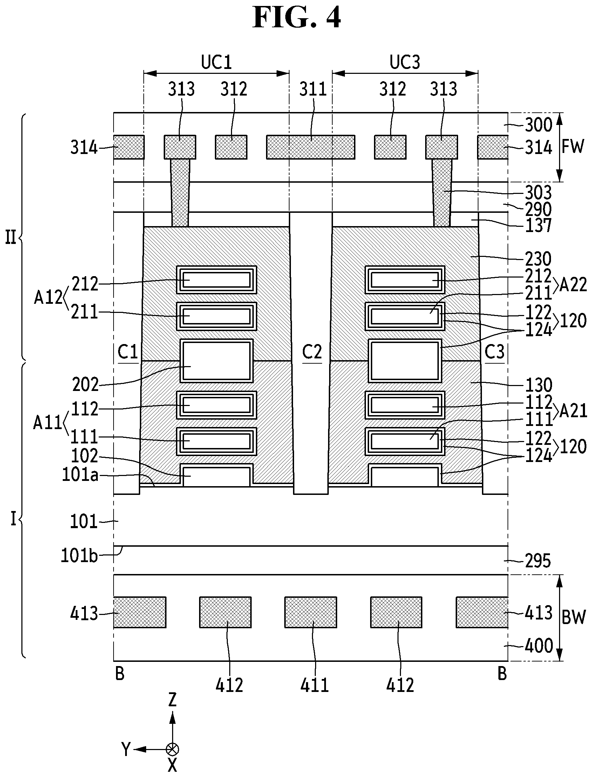

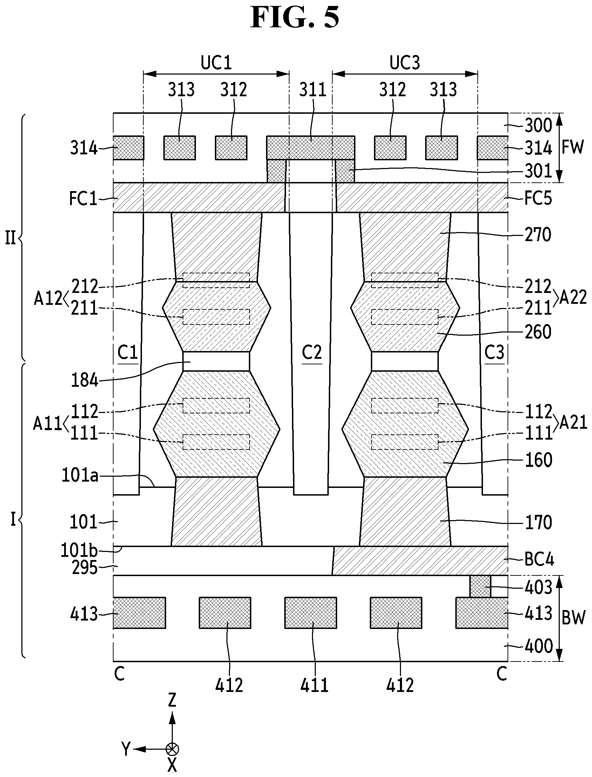

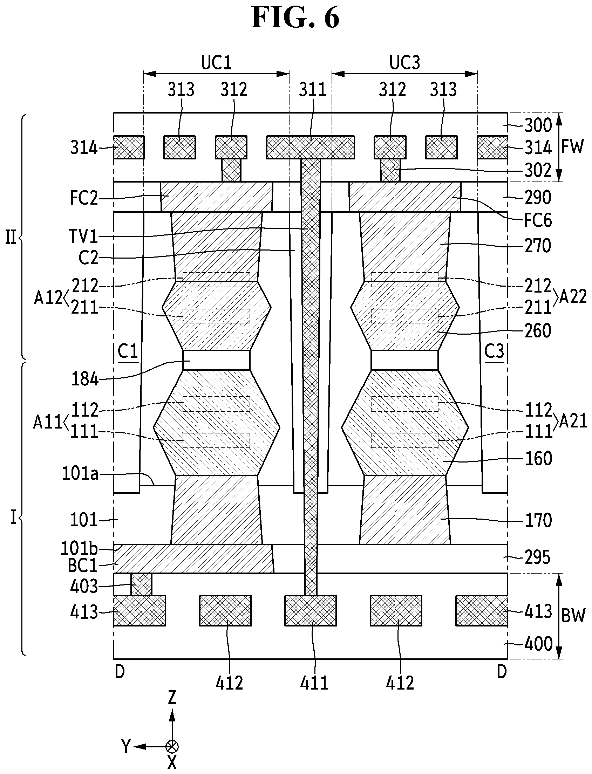

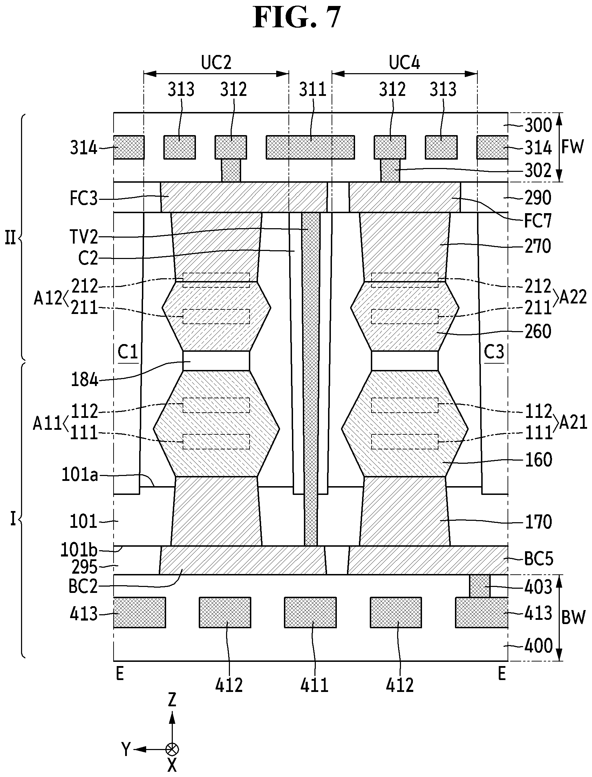

FIG. 2 is an example layout diagram for illustrating the R area in FIG. 1. FIG. 3 is a cross-sectional view cut along A-A in FIG. 2. FIG. 4 is a cross-sectional view cut along B-B in FIG. 2. FIG. 5 is a cross-sectional view cut along C-C in FIG. 2. FIG. 6 is a cross-sectional view cut along D-D in FIG. 2. FIG. 7 is a cross-sectional view cut along E-E in FIG. 2.

Referring to FIG. 1 to FIG. 7, in a semiconductor device according to some embodiments, the plurality of unit cell areas UC includes first, second, third, and fourth cell areas UC1, UC2, UC3, and UC4 that are adjacent to each other.

The first cell area DC1 and the second cell area UC2 may be adjacent to each other in the first direction X. The first cell area UC1 and the third cell area UC3 may be adjacent to each other in the second direction Y. The fourth cell area UC4 may be adjacent to the second cell area UC2 in the second direction Y and may be adjacent to the third cell area UC3 in the first direction X. That is, the fourth cell area UC4 may be adjacent to the first cell area UC1 in a diagonal direction between the first direction X and the second direction Y.

In the semiconductor device according to some embodiments, each of the first, second, third, and fourth cell areas UC1, UC2, UC3, and UC4 may include a first area I and a second area II.

The first area I and the second area II may be stacked sequentially along a third direction Z. Transistors of the same conductivity type may be respectively formed in the first area I and the second area II. In some embodiments, transistors of different conductivity types may be respectively formed in the first area I and the second area II. In a following description, the first area I is a PFET area and the second area II is a NFET area. However, this is only an example, and a person of ordinary skill in the technical field to which the present disclosure belongs will understand that the first area I may be the NFET area and the second area II may be the PFET area, or both the first area I and the second area II may be NFET areas, or both the first area I and the second area II may be PFET areas.

The semiconductor device according to some embodiments may include a substrate 101, a first active pattern A11 and A12, a second active pattern A21 and A22, first, second, third and fourth gate structures G1, G2, G3, and G4, first, second, third, fourth, fifth, and sixth isolation structures B1, B2, B3, B4, B5, and B6, first, second, and third cutting patterns C1, C2, and C3 (also referred to as cutting structures), a lower source/drain area 160, an upper source/drain area 260, a lower source/drain contact 170, an upper source/drain contact 270, first, second, third, fourth, fifth, sixth, seventh, and eighth upper connection contacts FC1, FC2, FC3, FC4, FC5, FC6, FC7, and FC8, first, second, third, fourth, and fifth lower connection contacts BC1, BC2, BC3, BC4, and BC5, a back wiring structure BW, a front wiring structure FW, a first through-via TV1, and a second through-via TV2.

The substrate 101 may be made of bulk silicon or SOI (silicon-on-insulator). In some embodiments, the substrate 101 may be a silicon substrate, or may include a material other than silicon, such as silicon germanium, silicon germanium on insulator (SGOI), indium antimonide, lead telluride compound, indium arsenide, indium phosphide, gallium arsenide, or gallium antimonide. In some embodiments, the substrate 101 may have a base substrate and an epitaxial layer formed on the base substrate.

In some embodiments, the substrate 101 may be an insulating substrate including an insulating material. For example, the substrate 101 may include at least one of silicon oxide, silicon oxynitride, silicon oxycarbonitride, and/or combinations thereof. However, embodiments of the present disclosure are not limited thereto. For example, the substrate 101 may include a silicon oxide film.

The substrate 101 may include a first surface 101a and a second surface 101b, which are opposite to each other. In the present disclosure, the first surface 101a may be referred to as a front surface of the substrate 101, and the second surface 101b may be referred to as a back surface of the substrate 101.

The first active pattern A11 and A12 and the second active pattern A21 and A22 may be formed on the first surface 101a. The first active pattern A11 and A12 and the second active pattern A21 and A22 may be spaced apart from each other in the second direction Y. Each of the first active pattern A11 and A12 and the second active pattern A21 and A22 may extend in an elongated manner in the first direction X. The first active pattern A11 and A12 may extend in the first direction X and across the first cell area UC1 and the second cell area UC2. The second active pattern A21 and A22 may extend in the first direction X and across the third cell area UC3 and fourth cell area UC4.

The first active pattern A11 and A12 may include a first lower active pattern A11 and a first upper active pattern A12 sequentially stacked on the first surface 101a. The first lower active pattern A11 and the first upper active pattern A12 may be spaced apart from each other in the third direction Z and each thereof may extend in an elongated manner in the first direction X. The first lower active pattern A11 may be disposed in the first area I, and the first upper active pattern A12 may be disposed in the second area II.

The second active pattern A21 and A22 may include a second lower active pattern A21 and a second upper active pattern A22 that are sequentially stacked on the first surface 101a. The second lower active pattern A21 and the second upper active pattern A22 may be spaced apart from each other in the third direction Z and each thereof may extend in an elongated manner in the first direction X. The second lower active pattern A21 may be disposed in the first area I, and the second upper active pattern A22 may be disposed in the second area II.

In some embodiments, each of the first lower active pattern A11 and the second lower active pattern A21 may include a plurality of lower bridge patterns 111 and 112 sequentially stacked on the substrate 101 and spaced apart from each other. In some embodiments, each of the first upper active pattern A12 and the second upper active pattern A22 may include a plurality of upper bridge patterns 211 and 212 which are sequentially stacked on the substrate 101 and spaced apart from each other. Each of the lower bridge patterns 111 and 112 and the upper bridge patterns 211 and 212 may be used as a channel area of a Multi-Bridge Channel FET (MBCFET^{®}) including a multi-bridge channel. Each of the number of lower bridge patterns 111 and 112 and the number of upper bridge patterns 211 and 212 may be merely an example, and is not limited to what is shown.

Each of the first lower active pattern A11, the first upper active pattern A12, the second lower active pattern A21, and the second upper active pattern A22 may include silicon (Si) or germanium (Ge) as an elemental semiconductor material. In some embodiments, each of the first lower active pattern A11, the first upper active pattern A12, the second lower active pattern A21, and the second upper active pattern A22 may include a compound semiconductor, for example, a group IV-IV compound semiconductor or a group III-V compound semiconductor. The group IV-IV compound semiconductor may include, for example, a binary compound including two of carbon (C), silicon (Si), germanium (Ge), and/or tin (Sn), a ternary compound including three thereof, or a compound obtained by doping a group IV element thereto. The group III-V compound semiconductor may include, for example, a binary compound obtained by combining one of aluminum (Al), gallium (Ga), and/or indium (In) as a group III element and/or one of phosphorus (P), arsenic (As), and/or antimony (Sb) as a group V element with each other, a ternary compound obtained by combining two of aluminum (Al), gallium (Ga), and indium (In) as a group III element and/or one of phosphorus (P), arsenic (As), and/or antimony (Sb) as a group V with each other, or a quaternary compound obtained by combining three of aluminum (Al), gallium (Ga), and/or indium (In) as a group III element and/or one of phosphorus (P), arsenic (As), and/or antimony (Sb) as a group V with each other.

In some embodiments, a base insulating pattern 102 may be formed between the substrate 101 and the lower active patterns A11 and A21. The base insulating pattern 102 may extend in an elongated manner in the first direction X. The base insulating pattern 102 may electrically insulate the substrate 101 from each of the lower active patterns A1 1 and A21. The base insulating pattern 102 may include, but is not limited to, at least one of silicon oxide, silicon oxynitride, silicon oxycarbonitride, and/or combinations thereof. In one example, the base insulating pattern 102 may include a silicon nitride film.

In some embodiments, an intermediate insulating pattern 202 may be formed between each of the lower active patterns A11 and A21 and each of the upper active patterns A12 and A22. The intermediate insulating pattern 202 may extend in an elongated manner in the first direction X. The intermediate insulating pattern 202 may electrically insulate each of the lower active patterns A11 and A21 and each of the upper active patterns A12 and A22 from each other. The intermediate insulating pattern 202 may include, but is not limited to, at least one of, for example, silicon oxide, silicon oxynitride, silicon oxycarbonitride, and/or combinations thereof. In one example, the intermediate insulating pattern 202 may include a silicon nitride film.

The first, second, third, and fourth gate structures G1, G2, G3, and G4 may be formed on the first active pattern A11 and A12 and the second active pattern A21 and A22. Each of the first, second, third, and fourth gate structures G1, G2, G3, and G4 may extend in an elongated manner in the second direction Y.

Each of the first gate structure G1 and the second gate structure G2 may intersect the first active patterns A11 and A12. The first gate structure G1 and the second gate structure G2 may be spaced apart from each other in the first direction X and each thereof may extend in the second direction Y. The first gate structure G1 may be disposed in the first cell area UC1, and the second gate structure G2 may be disposed in the second cell area UC2.

In some embodiments, the first gate structure G1 and the second gate structure G2 may surround the first active pattern A11 and A12. For example, each of the bridge patterns 111, 112, 211, and 212 of the first active pattern A11 and A12 may extend in the first direction X to extend through or into the first gate structure G1 and the second gate structure G2.

Each of the third gate structure G3 and the fourth gate structure G4 may intersect the second active pattern A21 and A22. The third gate structure G3 and the fourth gate structure G4 may be spaced apart from each other in the first direction X and each thereof may extend in the second direction Y. The third gate structure G3 may be disposed in the third cell area UC3, and the fourth gate structure G4 may be disposed in the fourth cell area UC4. The third gate structure G3 and the first gate structure G1 may be arranged along the second direction Y. The fourth gate structure G4 and the second gate structure G2 may be arranged along the second direction Y.

In some embodiments, the third gate structure G3 and the fourth gate structure G4 may surround the second active pattern A21 and A22. For example, each of the bridge patterns 111, 112, 211, and 212 of the second active pattern A21 and A22 extends in the first direction X to extend through or into the third gate structure G3 and the fourth gate structure G4.

In FIG. 2, it is shown that only one gate structure is disposed within each of the first, second, third, and fourth cell areas UC1, UC2, UC3, and UC4. However, this is only an example, and within each of the first, second, third, and fourth cell areas UC1, UC2, UC3, and UC4, a plurality of gate structures may be disposed.

Each of the first, second, third, and fourth gate structures G1, G2, G3, and G4 may include a gate dielectric film 120, a lower gate electrode 130, an upper gate electrode 230, a gate spacer 135, and a gate capping film 137.

The gate dielectric film 120 may be interposed between the lower active patterns A11 and A21 and the lower gate electrode 130 and between the upper active patterns A12 and A22 and the upper gate electrode 230. The gate dielectric film 120 may include at least one of a dielectric material, for example, silicon oxide, silicon oxynitride, silicon nitride, or a high dielectric constant material having a higher dielectric constant than that of silicon oxide. The high dielectric constant material may include at least one of, for example, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate and/or combinations thereof. However, embodiments of the present disclosure are not limited thereto.

In some embodiments, the gate dielectric film 120 may include an interfacial film 122 and a high dielectric constant (high-k) dielectric film 124 that are sequentially stacked on each of the bridge patterns 111, 112, 211, and 212.

The interfacial film 122 may surround each of the bridge patterns 111, 112, 211, and 212. For example, the interfacial film 122 may extend conformally along a periphery of each of the bridge patterns 111, 112, 211, and 212. In some embodiments, the interfacial film 122 may include an oxide film produced by oxidizing a surface of each of the bridge patterns 111, 112, 211, and 212. For example, when each of the bridge patterns 111, 112, 211, and 212 includes silicon (Si), the interfacial film 122 may include a silicon oxide film.

The high-k dielectric film 124 may surround a periphery of the interfacial film 122. Moreover, a portion of the high-k dielectric film 124 may be interposed between the upper gate electrode 230 and the gate spacer 135. For example, the high-k dielectric film 124 may extend conformally along the periphery of the interfacial film 122 and a profile of an inner side surface of the gate spacer 135. The high-k dielectric film 124 may further extend along the substrate 101, the base insulating pattern 102, and the intermediate insulating pattern 202.

In some embodiments, the high-k dielectric flim 124 may include a high-k material with a dielectric constant greater than that of silicon oxide. The high dielectric constant material may include at least one of for example, hafnium oxide (HfO₂), zirconium oxide (ZrO₂), lanthanum oxide (La₂O₃), aluminum oxide (Al₂O₃), titanium oxide (TiO₂), strontium titanium oxide (SrTiO₃), lanthanum aluminum oxide (LaAlO₃), yttrium oxide (Y₂O₃), hafnium oxynitride (HfOₓN_{y}), zirconium oxynitride (ZrOₓN_{y}), lanthanum oxynitride (La₂OₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓN_{y}) or combinations thereof. However, embodiments of the present disclosure are not limited thereto.

The lower gate electrode 130 may be disposed within the first area I. The lower gate electrode 130 may intersect the lower active patterns A11 and A21. For example, each of the lower bridge patterns 111 and 112 may extend in the first direction X so as to extend through or into the lower gate electrode 130.

The upper gate electrode 230 may be disposed in the second area II. The upper gate electrode 230 may intersect the upper active patterns A12 and A22. For example, each of the upper bridge patterns 211 and 212 may extend in the first direction X so as to extend through or into the upper gate electrode 230.

Each of the lower gate electrode 130 and the upper gate electrode 230 may include a conductive material, for example, at least one of TiN, WN, TaN, Ru, TiC, TaC, Ti, Ag, Al, TiAl, TiAlN, TiAlC, TaCN, TaSiN, Mn, Zr, W, Al, and/or combinations thereof. However, embodiments of the present disclosure are not limited thereto. Each of the lower gate electrode 130 and the upper gate electrode 230 may be formed in a replacement process. However, embodiments of the present disclosure are not limited thereto.

Each of the lower gate electrode 130 and the upper gate electrode 230 is shown as a single film. However, this is only an example. In some embodiments, each of the lower gate electrode 130 and the upper gate electrode 230 may be formed by stacking a plurality of conductive films. For example, each of the lower gate electrode 130 and the upper gate electrode 230 may include a work function control film that controls a work function, and a filling conductive film that fills a space defined by the work function control film. For example, the work function control film may include at least one of TiN, TaN, TiC, TaC, TiAlC, and/or combinations thereof. The filling conductive film may include, for example, W or Al.

In some embodiments, the lower gate electrode 130 and the upper gate electrode 230 may include different conductive materials. For example, the lower gate electrode 130 and the upper gate electrode 230 may include work function control films of different conductivity types, respectively. For example, the lower gate electrode 130 may include a p-type work function control film, and the upper gate electrode 230 may include an n-type work function control film.

The gate spacer 135 may extend along a side surface of the lower gate electrode 130 and a side surface of the upper gate electrode 230. Each of the bridge patterns 111, 112, 211, and 212 may extend in the first direction X so as to extend through or into the gate spacer 135. The gate spacer 135 may include an insulating material including at least one of silicon oxide, silicon nitride, silicon oxynitride, silicon oxycarbide, silicon boron nitride, silicon boron carbonitride, silicon oxycarbonitride, and/or combinations thereof. However, embodiments of the present disclosure are not limited thereto.

The gate capping film 137 may extend along an upper surface of the upper gate electrode 230. The gate capping film 137 may include an insulating material including at least one of silicon oxide, silicon nitride, silicon oxynitride, silicon oxycarbide, silicon boron nitride, silicon boron carbonitride, silicon oxycarbonitride, and/or combinations thereof. However, embodiments of the present disclosure are not limited thereto.

Each of the first, second, third, fourth, fifth, and sixth isolation structures B1, B2, B3, B4, B5, and B6 may extend in an elongated manner in the second direction Y. The first, second, third, fourth, fifth, and sixth isolation structures B1, B2, B3, B4, B5, and B6 may cut the first active pattern A11 and A12 and the second active pattern A21 and A22.

Each of the first, second, and third isolation structures B1, B2, and B3 may cut the first active pattern A11 and A12. The first, second, and third isolation structures B1, B2, and B3 may be spaced apart from each other in the first direction X and each thereof may extend in the second direction. The first, second, and third isolation structures B1, B2, and B3 may be spaced apart from the first gate structure G1 and the second gate structure G2 in the first direction X.

The first gate structure G1 may be interposed between the first isolation structure B1 and the second isolation structure B2. The first isolation structure B1 and the second isolation structure B2 may define the first cell area UC1 in the first direction X.

The second gate structure G2 may be interposed between the second isolation structure B2 and the third isolation structure B3. The second isolation structure B2 and the third isolation structure B3 may define the second cell area UC2 in the first direction X.

Each of the fourth, fifth, and sixth isolation structures B4, B5, and B6 may cut or intersect the second active pattern A21 and A22. The fourth, fifth, and sixth isolation structures B4, B5, and B6 may be spaced apart from each other in the first direction X and each thereof may extend in the second direction Y. The fourth, fifth, and sixth isolation structures B4, B5, and B6 may be spaced apart from the third gate structure G3 and the fourth gate structure G4 in the first direction X.

The third gate structure G3 may be interposed between the fourth isolation structure B4 and the fifth isolation structure B5. The fourth isolation structure B4 and the fifth isolation structure B5 may define the third cell area UC3 in the first direction X.

The fourth gate structure G4 may be interposed between the fifth isolation structure B5 and the sixth isolation structure B6. The fifth isolation structure B5 and the sixth isolation structure B6 may define the fourth cell area UC4 in the first direction X.

Each of the first, second, third, fourth, fifth, and sixth isolation structures B1, B2, B3, B4, B5, and B6 may include an insulating material, such as at least one of silicon oxide, silicon nitride, silicon oxynitride, silicon oxycarbide, silicon boron nitride, silicon boron carbonitride, silicon oxycarbonitride, and/or combinations thereof. However, the present disclosure is not limited thereto. In one example, each of the first, second, third, fourth, fifth, and sixth isolation structures B1, B2, B3, B4, B5, and B6 may include a silicon oxide film.

In accordance with the present disclosure, adjacent gate structures and/or isolation structures may be referred to as being spaced apart from each other by 1 gate pitch. 1 gate pitch may be defined as a sum of a distance between two adjacent gate structures (or a distance between a gate structure and an isolation structure adjacent to each other) and a width of one gate structure (or a width of one isolation structure). In some embodiments, 1 gate pitch may be defined as a distance between a center line of one gate structure and a center line of another gate structure adjacent thereto (or a center line of an isolation structure adjacent thereto). In one example, the first isolation structure B1 and the first gate structure G1 may be spaced apart from each other by 1 gate pitch.

The first, second, and third cutting patterns C1, C2, and C3 may be spaced apart from each other in the second direction Y, and each thereof may extend in an elongated manner in the first direction X. The first, second, and third cutting patterns C1, C2, and C3 may be spaced apart from the first active pattern A11 and A12 and the second active pattern A21 and A22 in the second direction Y. The first, second, and third cutting patterns C1, C2, and C3 may cut the first, second, third and fourth gate structures G1, G2, G3, and G4.

The first active pattern A11 and A12 may be interposed between the first cutting pattern C1 and the second cutting pattern C2. The first cutting pattern C1 and the second cutting pattern C2 may define the first cell area UC1 and the second cell area UC2 in the second direction Y. The first gate structure G1, the second gate structure G2, and the first, second, and third isolation structures B1, B2, and B3 may be cut by the first cutting pattern C1 and the second cutting pattern C2. Each of the first gate structure G1, the second gate structure G2, and the first, second, and third isolation structures B1, B2, and B3 may extend in the second direction Y and between the first cutting pattern C1 and the second cutting pattern C2.

The second active pattern A21 and A22 may be interposed between the second cutting pattern C2 and the third cutting pattern C3. The second cutting pattern C2 and the third cutting pattern C3 may define the third cell area UC3 and the fourth cell area UC4 in the second direction Y. The third gate structure G3, the fourth gate structure G4, and the fourth to sixth isolation structure B4 to B6 may be cut by the second cutting pattern C2 and the third cutting pattern C3. Each of the third gate structure G3, the fourth gate structure G4, and the fourth, fifth, and sixth isolation structures B4, B5, and B6 may extend in the second direction Y and between the second cutting pattern C2 and the third cutting pattern C3.

Each of the first, second, and third cutting patterns C1, C2, and C3 may include an insulating material, such as at least one of silicon oxide, silicon nitride, silicon oxynitride, silicon oxycarbide, silicon boron nitride, silicon boron carbonitride, silicon oxycarbonitride, and/or combinations thereof. However, embodiments of the present disclosure are not limited thereto. In one example, each of the first, second, and third cutting patterns C1, C2, and C3 may include a silicon nitride film.

The lower source/drain area 160 may be formed in the lower active patterns A11 and A21 and on a side surface of each of the first, second, third and fourth gate structures G1, G2, G3, and G4 and a side surface of each of the first, second, third, fourth, fifth, and sixth isolation structures B1, B2, B3, B4, B5, and B6. The lower bridge patterns 111 and 112 may extend through or into the lower gate electrode 130 and the gate spacer 135 so as to contact the lower source/drain area 160. The lower source/drain area 160 may be isolated from the lower gate electrode 130 via the gate spacer 135 and/or the gate dielectric film 120. In the present disclosure, the lower source/drain area 160 may be described as a component included in the lower active patterns A11 and A21, or may be described as a separate component different from the lower active patterns A11 and A21.

In some embodiments, the lower source/drain area 160 may include an epitaxial layer doped with impurities. For example, the lower source/drain area 160 may include an epitaxial pattern grown by an epitaxial growth method from the lower active patterns A11 and A21. When the lower active patterns A11 and A21 act as a channel area of the PFET, the lower source/drain area 160 may contain P-type impurities (e.g., B, In, Ga or Al) and/or impurities to prevent diffusion of the P-type impurities.

The upper source/drain area 260 may be formed in the upper active patterns A12 and A22 and on a side surface of each of the first, second, third and fourth gate structures G1, G2, G3, and G4 and a side surface of each of the first, second, third, fourth, fifth, and sixth isolation structures B1, B2, B3, B4, B5, and B6. The upper bridge patterns 211 and 212 may extend through or into the upper gate electrode 230 and the gate spacer 135 so as to contact the upper source/drain area 260. The upper source/drain area 260 may be isolated from the upper gate electrode 230 by the gate spacer 135 and/or the gate dielectric film 120. In the present disclosure, the upper source/drain area 260 may be described as a component included in the upper active patterns A12 and A22, or may be described as a separate component different from the upper active patterns A12 and A22.

In some embodiments, the upper source/drain area 260 may include an epitaxial layer doped with impurities. For example, the upper source/drain area 260 may include an epitaxial pattern grown from the upper active patterns A12 and A22 by an epitaxial growth method. When the upper active patterns A12 and A22 act as a channel area of the NFET, the upper source/drain area 260 may contain N-type impurities (e.g., P, Sb or As) and/or impurities to prevent diffusion of the N-type impurities.

In some embodiments, an intermediate insulating layer 182 may be formed between the lower source/drain area 160 and the upper source/drain area 260. The intermediate insulating layer 182 may cover or overlap the lower source/drain area 160, and the upper source/drain area 260 may be formed on the intermediate insulating layer 182. The intermediate insulating layer 182 may electrically insulate the lower source/drain area 160 and the upper source/drain area 260 from each other. The intermediate insulating layer 182 may include, but is not limited to, at least one of, for example, silicon oxide, silicon oxynitride, silicon oxycarbonitride, and/or combinations thereof.

In some embodiments, an intermediate spacer 184 may be formed between the intermediate insulating pattern 202 and the intermediate insulating layer 182. The intermediate spacer 184 may extend along a side surface of the intermediate insulating pattern 202. The intermediate spacer 184 may be interposed between the lower source/drain area 160 and the upper source/drain area 260. The intermediate spacer 184 may include an insulating material, such as at least one of, for example, silicon oxide, silicon oxynitride, silicon oxycarbonitride, and/or a combination thereof. However, embodiments of the present disclosure are not limited thereto.

A first interlayer insulating film 280 may partially or completely fill a space on an outer side surface of the gate spacer 135. The first interlayer insulating film 280 may include at least one of, for example, silicon oxide, silicon nitride, silicon oxynitride, silicon oxycarbide, silicon boron nitride, boron silicon carbonitride, silicon oxycarbonitride, and/or a low dielectric constant material having a dielectric constant lower than that of silicon oxide. However, embodiments of the present disclosure are not limited thereto.

The lower source/drain contact 170 may be in contact with the lower source/drain area 160. For example, the lower source/drain contact 170 may extend in the third direction Z through the substrate 101 so as to contact the lower source/drain area 160. Thus, the lower source/drain contact 170 may be electrically connected to the lower source/drain area 160 of the lower active patterns A11 and A21.

The upper source/drain contact 270 may be in contact with the upper source/drain area 260. For example, the upper source/drain contact 270 may extend in the third direction Z through the first interlayer insulating film 280 so as to contact the upper source/drain area 260. Thus, the upper source/drain contact 270 may be electrically connected to the upper source/drain area 260 of the upper active patterns A12 and A22.

Each of the first, second, third, fourth, and fifth lower connection contacts BC1, BC2, BC3, BC4, and BC5 may be in contact with the lower source/drain contact 170. For example, a lower interlayer insulating film 295 covering or overlapping the substrate 101 and the lower source/drain contact 170 may be formed on the second surface 101b of the substrate 101. The first, second, third, fourth, and fifth lower connection contacts BC1, BC2, BC3, BC4, and BC5 may extend through or into the lower interlayer insulating film 295 so as to contact the lower source/drain contact 170. The first, second, third, fourth, and fifth lower connection contacts BC1, BC2, BC3, BC4, and BC5 may be electrically connected to the lower source/drain area 160 of the lower active patterns A11 and A21 via the lower source/drain contact 170. In descriptions as set forth below, the number, shape, and arrangement of the first, second, third, fourth, and fifth lower connection contacts BC1, BC2, BC3, BC4, and BC5 are only examples, and are not limited to what are shown. Unlike what is shown, at least some of the first, second, third, fourth, and fifth lower connection contacts BC1, BC2, BC3, BC4, and BC5 may be omitted.

The first lower connection contact BC1 may be in contact with the lower source/drain contact 170 disposed between the first gate structure G1 and the second isolation structure B2. The second lower connection contact BC2 may be in contact with the lower source/drain contact 170 disposed between the second isolation structure B2 and the second gate structure G2. The third lower connection contact BC3 may be in contact with the lower source/drain contact 170 disposed between the second gate structure G2 and the third isolation structure B3. The fourth lower connection contact BC4 may be in contact with the lower source/drain contact 170 disposed between the fourth isolation structure B4 and the third gate structure G3. The fifth lower connection contact BC5 may be in contact with the lower source/drain contact 170 disposed between the fifth isolation structure B5 and the fourth gate structure G4.

Each of the first, second, third, fourth, fifth, sixth, seventh, and eighth upper connection contacts FC1, FC2, FC3, FC4, FC5, FC6, FC7, and FC8 may be in contact with the upper source/drain contact 270. For example, a second interlayer insulating film 290 covering the first, second, third and fourth gate structures G1, G2, G3, and G4, the first interlayer insulating film 280, and the upper source/drain contact 270 may be formed on an upper surface of the first interlayer insulating film 280. The first, second, third, fourth, fifth, sixth, seventh, and eighth upper connection contacts FC1, FC2, FC3, FC4, FC5, FC6, FC7, and FC8 may extend through or into the second interlayer insulating film 290 so as to contact the upper source/drain contact 270. The first, second, third, fourth, fifth, sixth, seventh, and eighth upper connection contacts FC1, FC2, FC3, FC4, FC5, FC6, FC7, and FC8 may be electrically connected to the upper source/drain area 260 of the upper active patterns A12 and A22 via the upper source/drain contact 270. In following descriptions, the number, shape, and arrangement of the first, second, third, fourth, fifth, sixth, seventh, and eighth upper connection contacts FC1, FC2, FC3, FC4, FC5, FC6, FC7, and FC8 are only examples, and are not limited to what are shown. Unlike what is shown, at least some of the first, second, third, fourth, fifth, sixth, seventh, and eighth upper connection contacts FC1, FC2, FC3, FC4, FC5, FC6, FC7, and FC8 may be omitted.

The first upper connection contact FC1 may be in contact with the upper source/drain contact 270 disposed between the first isolation structure B1 and the first gate structure G1. The second upper connection contact FC2 may be in contact with the upper source/drain contact 270 disposed between the first gate structure G1 and the second isolation structure B2. The third upper connection contact FC3 may be in contact with the upper source/drain contact 270 disposed between the second isolation structure B2 and the second gate structure G2. The fourth upper connection contact FC4 may be in contact with the upper source/drain contact 270 disposed between the second gate structure G2 and the third isolation structure B3. The fifth upper connection contact FC5 may be in contact with the upper source/drain contact 270 disposed between the fourth isolation structure B4 and the third gate structure G3. The sixth upper connection contact FC6 may be in contact with the upper source/drain contact 270 disposed between the third gate structure G3 and the fifth isolation structure B5. The seventh upper connection contact FC7 may be in contact with the upper source/drain contact 270 disposed between the fifth isolation structure B5 and the fourth gate structure G4. The eighth upper connection contact FC8 may be in contact with the upper source/drain contact 270 disposed between the fourth gate structure G4 and the sixth isolation structure B6.

The back wiring structure BW may be formed on the second surface 101b of the substrate 101. For example, the back wiring structure BW may include a back inter-wiring insulating film 400 covering or overlapping the lower interlayer insulating film 295 and back wiring patterns 411, 412, and 413 disposed within the back inter-wiring insulating film 400. The back wiring patterns 411, 412, and 413 may be insulated from each other via the back inter-wiring insulating film 400. The number, shape, and arrangement of the back wiring patterns 411, 412, and 413 are only examples and are not limited to what are shown.

In some embodiments, the back wiring patterns 411, 412, and 413 may include a first back wiring pattern 411, a second back wiring pattern 412, and a third back wiring pattern 413. The first back wiring pattern 411, the second back wiring pattern 412, and the third back wiring pattern 413 may be spaced apart from each other in the second direction Y, and each thereof may extend in an elongated manner in the first direction X.

The first back wiring patterns 411 and the third back wiring patterns 413 may be alternately arranged with each other in the second direction Y. The second back wiring pattern 412 may be interposed between the first back wiring pattern 411 and the third back wiring pattern 413 in the second direction Y. In some embodiments, one first back wiring pattern 411 may overlap the second cutting pattern C2 in the third direction Z. In some embodiments, one third back wiring pattern 413 may overlap the first cutting pattern C1 in the third direction Z, and another third back wiring pattern 413 may overlap with the third cutting pattern C3 in the direction Z.

In some embodiments, each of the first back wiring pattern 411 and the third back wiring pattern 413 may act as a power line (e.g., V_{SS} or V_{DD}) that supplies power to the first, second, third, and fourth cell areas UC1, UC2, UC3, and UC4. For example, the first back wiring pattern 411 may be provided as the first power wiring PR1 in FIG. 1, and the third back wiring pattern 413 may be provided as the second power wiring PR2 in FIG. 1. The first back wiring pattern 411 may apply a first power voltage (e.g., V_{SS}) to the first, second, third, and fourth cell areas UC1, UC2, UC3, and UC4. The third back wiring pattern 413 may apply the second power voltage (e.g., V_{DD}) to the first, second, third, and fourth cell areas UC1, UC2, UC3, and UC4.

In some embodiments, the first cell area UC1 and the second cell area UC2 may share one third back wiring pattern 413. For example, a portion of the first lower connection contact BC 1 and a portion of the third lower connection contact BC3 may overlap with the third back wiring pattern 413 in the third direction Z. Each of the first lower connection contact BC1 and the third lower connection contact BC3 may be electrically connected to one third back wiring pattern 413 via a back via pattern 403 extending in the third direction Z.

In some embodiments, the third cell area UC3 and the fourth cell area UC4 may share another third back wiring pattern 413. For example, a portion of the fourth lower connection contact BC4 and a portion of the fifth lower connection contact BC5 may overlap with another third back wiring pattern 413 in the third direction Z. Each of the fourth lower connection contact BC4 and the fifth lower connection contact BC5 may be electrically connected to another third back wiring pattern 413 via the back via pattern 403 extending in the third direction Z.

The front wiring structure FW may be formed on the first surface 101a of the substrate 101. For example, the front wiring structure FW may include a front inter-wiring insulating film 300 covering or on the second interlayer insulating film 290 and front wiring patterns 311, 312, 313, and 314 disposed within the front inter-wiring insulating film 300. The front wiring patterns 311, 312, 313, and 314 may be insulated from each other via the front inter-wiring insulating film 300. The number, shape, and arrangement of the front wiring patterns 311, 312, 313, and 314 are only examples, and are not limited to what are shown.

In some embodiments, the front wiring patterns 311, 312, 313, and 314 may include a first front wiring pattern 311, a second front wiring pattern 312, a third front wiring pattern 313, and a fourth front wiring pattern 314. The first front wiring pattern 311, the second front wiring pattern 312, the third front wiring pattern 313, and the fourth front wiring pattern 314 may be spaced apart from each other in the second direction Y, and each thereof may extend in an elongated manner in the first direction X.

The first front wiring patterns 311 and the fourth front wiring patterns 314 may be alternately arranged with each other in the second direction Y. The second front wiring pattern 312 and the third front wiring pattern 313 may be interposed between the first front wiring pattern 311 and the fourth front wiring pattern 314 in the second direction Y. In some embodiments, one first front wiring pattern 311 may overlap the second cutting pattern C2 in the third direction Z. In some embodiments, one of the fourth front wiring pattern 314 may overlap the first cutting pattern C1 in the third direction Z, and another fourth front wiring pattern 314 may overlap with the third cutting pattern C3 in the third direction Z.

In some embodiments, the first, second, third, and fourth cell areas UC1, UC2, UC3, and UC4 may share one first front wiring pattern 311. For example, each of a portion of the first upper connection contact FC1, a portion of the fourth upper connection contact FC4, a portion of the fifth upper connection contact FC5, and a portion of the eighth upper connection contact FC8 may overlap with one first front wiring pattern 311 in the third direction Z. Each of the first upper connection contact FC1, the fourth upper connection contact FC4, the fifth upper connection contact FC5, and the eighth upper connection contact FC8 may be electrically connected to one first front wiring pattern 311 via a first front via pattern 301 extending in the third direction Z.

In some embodiments, the second front wiring pattern 312 may be electrically connected to the upper source/drain area 260 of the upper active patterns A12 and A22. For example, each of a portion of the second upper connection contact FC2, a portion of the third upper connection contact FC3, a portion of the sixth upper connection contact FC6, and a portion of the seventh upper connection contact FC7 may overlap with the second front wiring pattern 312 in the third direction Z. Each of the second upper connection contact FC2, the third upper connection contact FC3, the sixth upper connection contact FC6, and the seventh upper connection contact FC7 may be electrically connected to the second front wiring pattern 312 via a second front via pattern 302 extending in the third direction Z.

In some embodiments, the third front wiring pattern 313 may be electrically connected to the first, second, third and fourth gate structures G1, G2, G3, and G4. For example, the upper gate electrode 230 of each of the first, second, third and fourth gate structures G1, G2, G3, and G4 may overlap the third front wiring pattern 313 in the third direction Z. The upper gate electrode 230 of each of the first, second, third and fourth gate structures G1, G2, G3, and G4 may be electrically connected to the third front wiring pattern 313 via a third front via pattern 303 extending in the third direction Z.

In some embodiments, a width of the first front wiring pattern 311 may be greater than a width of each of the second to fourth front wiring patterns 312, 313, and 314. In this regard, the width refers to a width in the second direction Y.

The first through-via TV1 may be interposed between the first cell area UC1 and the third cell area UC3. The first through-via TV1 may extend in the third direction Z through or into the substrate 101 and the second cutting pattern C2. The first through-via TV1 may electrically connect the first back wiring pattern 411 and the first front wiring pattern 311 to each other. The first through-via TV1 may include a conductive material, for example, tungsten (W) or aluminum (Al). However, embodiments of the present disclosure are not limited thereto.

As the first front wiring pattern 311 is electrically connected to the first back wiring pattern 411 via the first through-via TV1, the first front wiring pattern 311 may also be provided as the first power wiring PR1 in FIG. 1. For example, the first front wiring pattern 311 may apply the first power voltage (e.g., V_{SS}) to the first, second, third, and fourth cell areas UC1, UC2, UC3, and UC4.

In some embodiments, a width of the first through-via TV1 may be smaller than or less than a width of the second cutting pattern C2. In this regard, the width refers to the width in the second direction Y.

In some embodiments, the first through-via TV1 may not be aligned with the first, second, third and fourth gate structures G1, G2, G3, and G4 and/or the first, second, third, fourth, fifth, and sixth isolation structures B1, B2, B3, B4, B5, and B6 along the second direction Y. For example, as shown, the first through-via TV1 may be aligned with the second upper connection contact FC2 and the sixth upper connection contact FC6 in the second direction Y.

In some embodiments, the width of the first through-via TV1 may decrease as the first through-via TV1 extends in a direction from the second area II toward the first area I. This may be due to the fact that the etching process for forming the first through-via TV1 is performed in a direction from the second area II to the first area I. However, embodiments of the present disclosure are not limited thereto.

The second through-via TV2 may be aligned with the first through-via TV1 in the first direction X. The second through-via TV2 may extend in the third direction Z through the substrate 101 and the second cutting pattern C2. The second through-via TV2 may electrically connect the lower source/drain area 160 and the upper source/drain area 260 to each other. For example, a portion of the second lower connection contact BC2 and a portion of the third upper connection contact FC3 may overlap the second cutting pattern C2 in the third direction Z. The second through-via TV2 extends in the third direction Z so as to connect the second lower connection contact BC2 and the third upper connection contact FC3 to each other.

In some embodiments, a width of the second through-via TV2 may be smaller than or less than the width of the second cutting pattern C2. In this regard, the width refers to the width in the second direction Y.

In some embodiments, the width of the second through-via TV2 may decrease as the second through-via TV2 extends in a direction from the second area II toward the first area I. This may be due to the fact that the etching process for forming the second through-via TV2 is performed in a direction from the second area II to the first area I. However, embodiments of the present disclosure are not limited thereto.

As the semiconductor device becomes more highly integrated, individual circuit patterns are becoming increasingly finer to implement a larger number of elements in the same area. For this purpose, the semiconductor device using a stacked multi-gate transistor in which a multi-gate transistor of an upper area (e.g., the second area II) is stacked on a multi-gate transistor of a lower area (e.g., the first area I) is being researched.

Furthermore, in order to reduce voltage drop (e.g., IR drop) of a power delivery network (PDN) provided to the stacked multi-gate transistor, a so-called BSPDN (Back Side Power Delivery Network) in which voltage is provided from a back of the substrate 101 may be provided. However, connection between the BSPDN and the upper area is causing various problems due to its complexity.

For example, within a unit cell area, a tall via extending in an elongated manner across the lower and upper areas may be provided to connect the BSPDN and the upper area to each other. However, an area of a portion of the tall via adjacent to the gate structure is larger than that of a via that extends only in the lower area or a via that extends only in the upper area, thereby increasing a parasitic capacitance thereof with the gate structure, thereby causing the performance of the semiconductor device to deteriorate. Accordingly, in addition to the unit cell area, a tap cell that electrically connects the BSPDN and the front wiring pattern to each other may be disposed separately. This tap cell requires an additional area, which reduces the integration density of the semiconductor device.

In contrast thereto, the semiconductor device according to some embodiments may provide improved integration density and performance using the first through-via TV1. Specifically, as described above, the first through-via TV1 may be disposed between unit cell areas adjacent to each other in the second direction Y (e.g., between the first cell area UC1 and the third cell area UC3). Furthermore, the first through-via TV1 may connect the first back wiring pattern 411 with the first front wiring pattern 311 so as to apply the first power voltage (e.g., V_{SS}) to the second area II. Since this first through-via TV1 does not require an additional area to connect the back wiring structure BW and the second area II to each other, the improved integration density of the device may be achieved. Furthermore, as described above, the first through-vias TV1 may be arranged so as to be spaced from each other by a predetermined spacing in the first direction X, and may be disposed in an area other than an area of another tall via (e.g., the second through-via TV2). Thus, the connection complexity between the BSPDN and the upper area may be lowered such that the semiconductor device with improved integration density and performance may be provided.

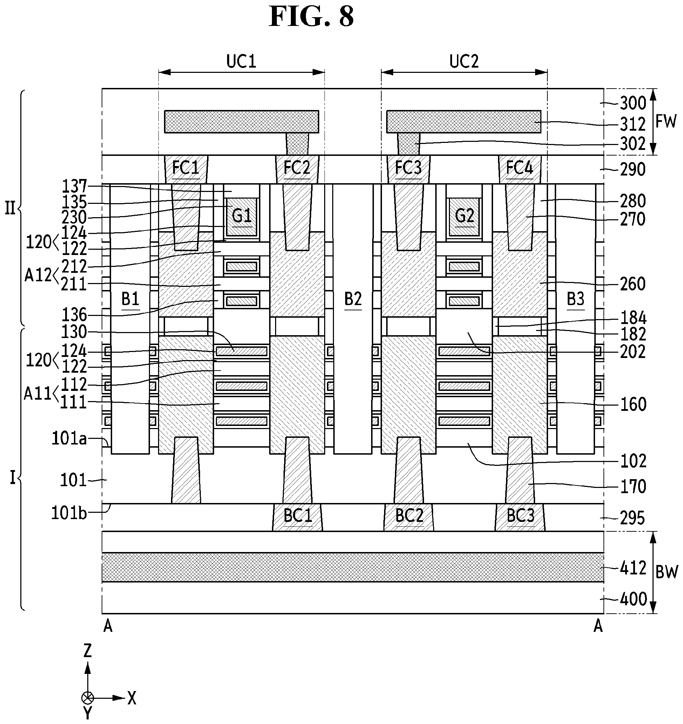

FIG. 8 is a cross-sectional view for illustrating a semiconductor device according to some embodiments. For convenience of description, contents duplicate with those described above with reference to FIG. 1 to FIG. 7 are briefly described or descriptions thereof are omitted. For reference, FIG. 8 is another cross-sectional view cut along A-A in FIG. 2.

Referring to FIG. 2 and FIG. 8, in the semiconductor device according to some embodiments, each of the first, second, third and fourth gate structures G1, G2, G3, and G4 further includes an inner spacer 136.

The inner spacer 136 may be formed within the second area II. The inner spacer 136 may be formed on a side surface of the upper gate electrode 230 between the upper bridge patterns 211 and 212. The inner spacer 136 may be formed on a side surface of the upper gate electrode 230 between the intermediate insulating pattern 202 and the upper active patterns A12 and A22. The upper source/drain area 260 may be isolated from the upper gate electrode 230 via the gate spacer 135, the inner spacer 136, and/or the gate dielectric film 120.

Only a configuration that the inner spacer 136 is not formed within the first area I is shown. However, this embodiment is an example. Unlike what is shown, the inner spacer 136 may be formed in both the first area I and the second area II. In some embodiments, unlike what is shown, the inner spacer 136 may be formed in the first area I and not in the second area II.

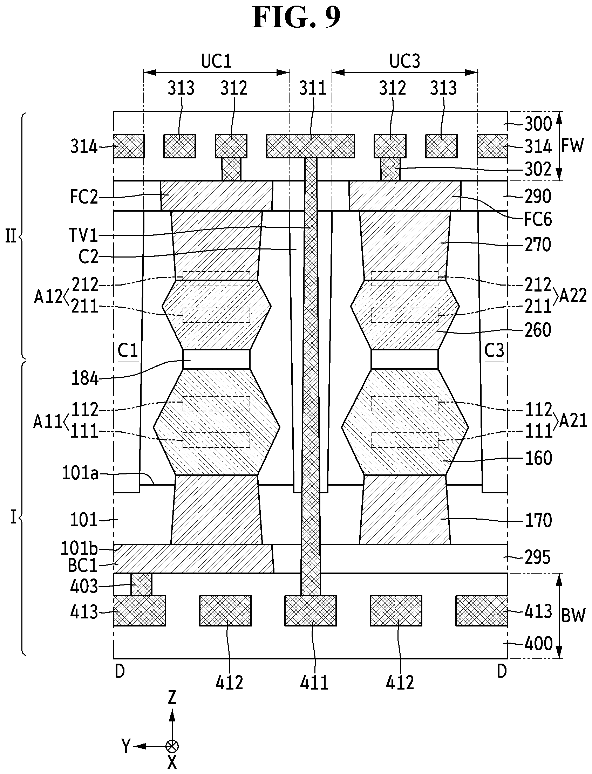

FIG. 9 is a cross-sectional view for illustrating a semiconductor device according to some embodiments. For convenience of description, contents duplicate with those described above with reference to FIG. 1 to FIG. 7 are briefly described or descriptions thereof are omitted. For reference, FIG. 9 is another cross-sectional view cut along D-D in FIG. 2.

Referring to FIG. 2 and FIG. 9, in the semiconductor device according to some embodiments, the width of the first through-via TV1 decreases as the first through-via TV1 extends in a direction from the first area I toward the second area II.

This may be due to the fact that the etching process for forming the first through-via TV1 is performed in a direction from the first area I to the second area II. However, embodiments of the present disclosure are not limited thereto.

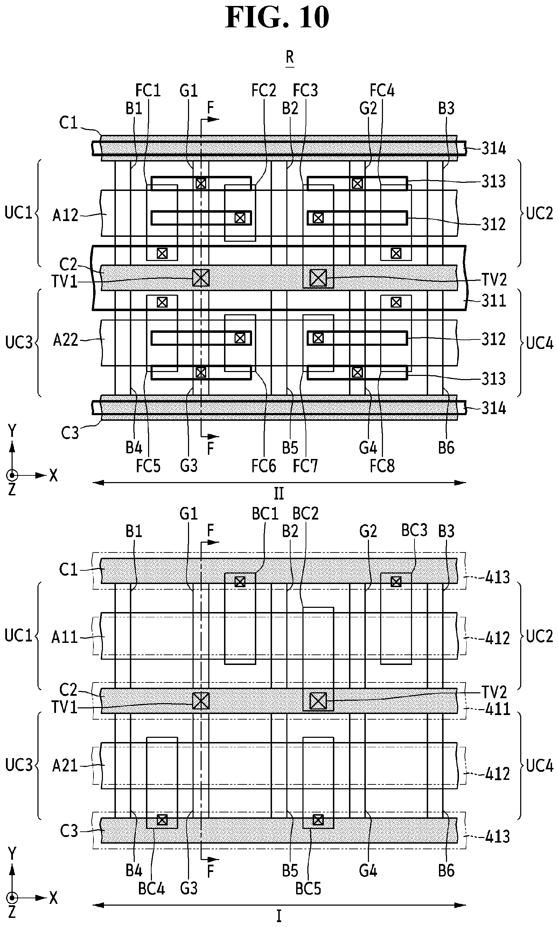

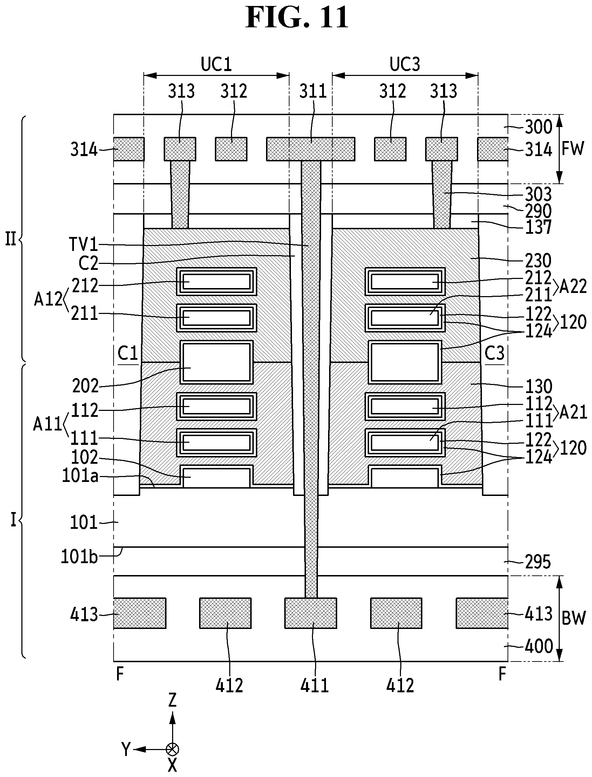

FIG. 10 is an example layout diagram for illustrating a semiconductor device according to some embodiments. FIG. 11 is a cross-sectional view cut along F-F in FIG. 10. For convenience of description, contents duplicate with those described above with reference to FIG. 1 to FIG. 7 are briefly described or descriptions thereof are omitted.

Referring to FIG. 10 and FIG. 11, in the semiconductor device according to some embodiments, the first through-via TV1 is not aligned with the first, second, third, fourth, fifth, sixth, seventh, and eighth upper connection contacts FC1, FC2, FC3, FC4, FC5, FC6, FC7, and FC8 and/or the first, second, third, fourth, and fifth lower connection contacts BC1, BC2, BC3, BC4, and BC5 in the second direction Y.

For example, as shown, the first through-via TV1, the first gate structure G1, and the third gate structure G3 may be aligned with each other along the second direction Y.

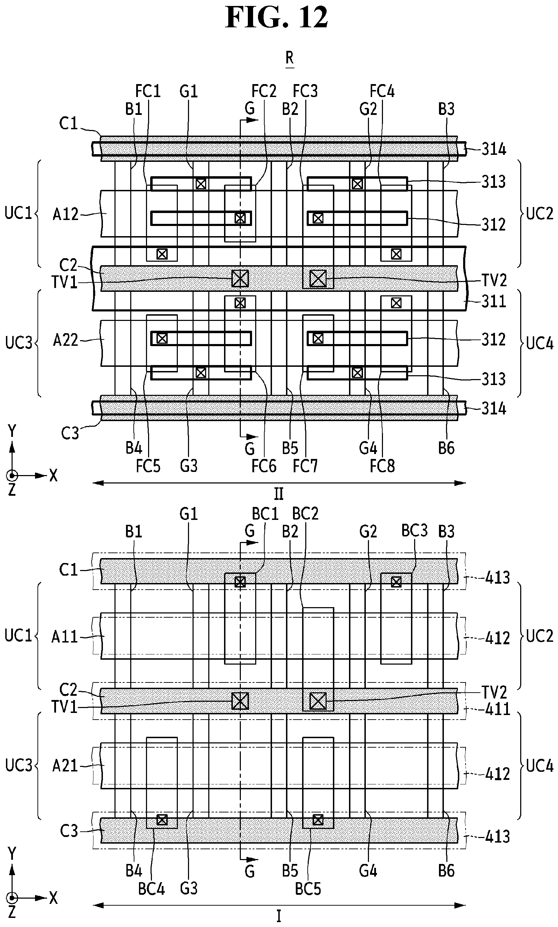

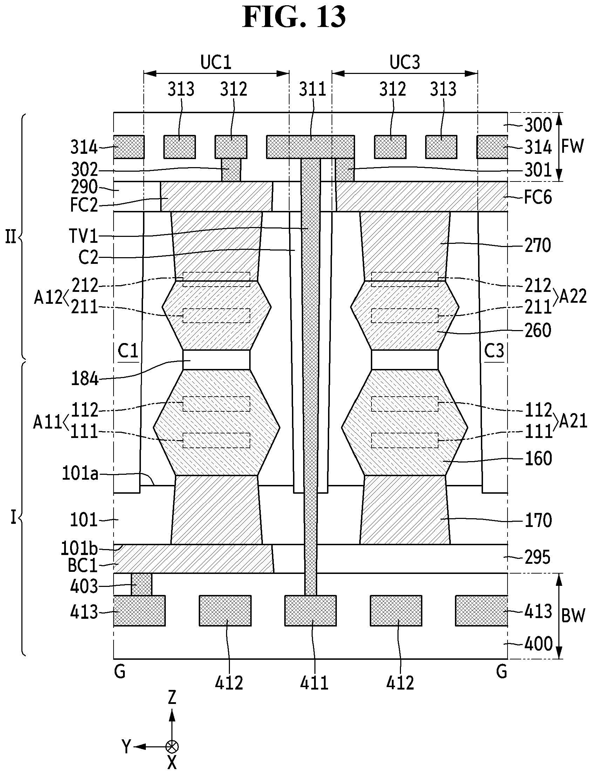

FIG. 12 is an example layout diagram for illustrating a semiconductor device according to some embodiments. FIG. 13 is a cross-sectional view cut along G-G in FIG. 12. For convenience of description, contents duplicate with those described above with reference to FIG. 1 to FIG. 7 are briefly described or descriptions thereof are omitted.

Referring to FIG. 12 and FIG. 13, in the semiconductor device according to some embodiments, the first through-via TV1 and the first front via pattern 301 are aligned with each other along the second direction Y.

For example, a portion of the sixth upper connection contact FC6 may overlap the first front wiring pattern 311 in the third direction Z. The sixth upper connection contact FC6 may be electrically connected to the first front wiring pattern 311 via the first front via pattern 301 extending in the third direction Z. The first through-via TV1 and the sixth upper connection contact FC6 may be aligned with each other along the second direction Y.

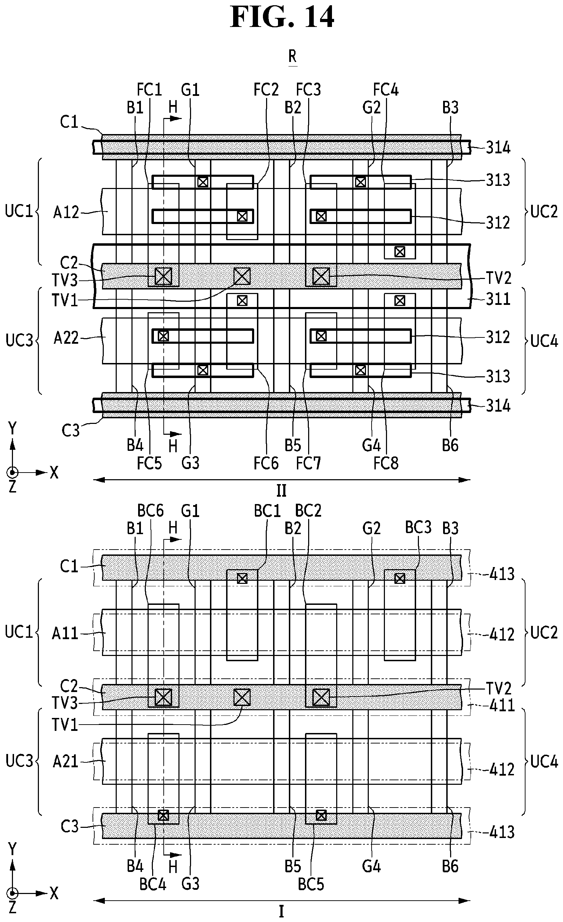

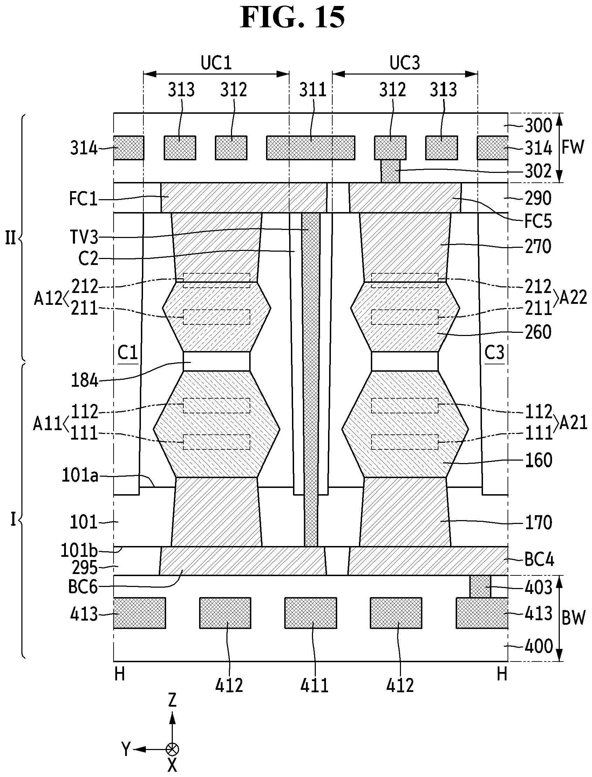

FIG. 14 is an example layout diagram for illustrating a semiconductor device according to some embodiments. FIG. 15 is a cross-sectional view cut along H-H in FIG. 14. For convenience of description, contents duplicate with those described above with reference to FIG. 1 to FIG. 7 are briefly described or descriptions thereof are omitted.

Referring to FIG. 14 and FIG. 15, the semiconductor device according to some embodiments further includes a third through-via TV3.

The third through-via TV3 and the first through-via TV1 may be aligned with each other along the first direction X. The third through-via TV3 may extend in the third direction Z through or into the substrate 101 and the second cutting pattern C2. The third through-via TV3 may electrically connect the lower source/drain area 160 and the upper source/drain area 260 to each other. For example, each of a portion of the sixth lower connection contact BC6 and a portion of the first upper connection contact FC1 may overlap the second cutting pattern C2 in the third direction Z. The third through-via TV3 may extend in the third direction Z so as to connect the sixth lower connection contact BC6 and the first upper connection contact FC1 to each other.

Only a configuration that the third through-via TV3 connects the lower source/drain area 160 and the upper source/drain area 260 to each other in the first cell area UC1 is shown. However, this is only an example. The third through-via TV3 may electrically connect the lower source/drain area 160 and the upper source/drain area 260 to each other in the third cell area UC3 and/or fourth cell area UC4.

In some embodiments, a width of the third through-via TV3 may be less than the width of the second cutting pattern C2. In this regard, the width refers to the width in the second direction Y.

In some embodiments, the width of the third through-via TV3 may decrease as the third through-via TV3 extends in a direction from the second area II toward the first area I. This may be due to the fact that the etching process for forming the third through-via TV3 is performed in the direction from the second area II to the first area I. However, embodiments of the present disclosure are not limited thereto.

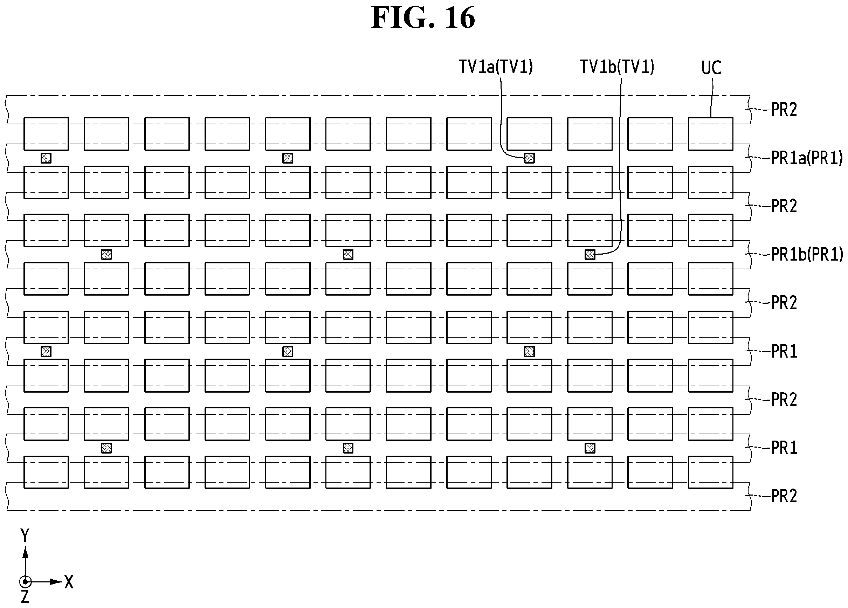

FIG. 16 to FIG. 18 are various schematic layout diagrams for illustrating a semiconductor device according to some embodiments. For convenience of description, contents duplicate with those described above with reference to FIG. 1 to FIG. 15 are briefly described or descriptions thereof are omitted.

Referring to FIG. 16, in the semiconductor device according to some embodiments, at least some of the plurality of first through-vias TV1 may be arranged in a zigzag manner in the second direction Y.

For example, the first power wiring PR1 may include a first power line PR1a and a second power line PR1b. The first power line PR1a and the second power line PR1b may be spaced apart from each other in the second direction Y and each thereof may extend in an elongated manner in the first direction X.

The first through-via TV1 may include a plurality of first sub-through-vias TV1a and a plurality of second sub-through-vias TV1b. The plurality of first sub-through-vias TV1a may be arranged along the first direction X and may be spaced from each other by a predetermined spacing. The first power line PR1a may be commonly connected to the plurality of first sub-through-vias TV1a. the plurality of second sub-through-vias TV1b may be arranged along the first direction X and may be spaced from each other by a predetermined spacing. The second power line PR1b may be commonly connected to the plurality of second sub-through-vias TV1b. In some examples, the first sub-through-via TV1a and the second sub-through-via TV1b may not be aligned with each other along the second direction Y.

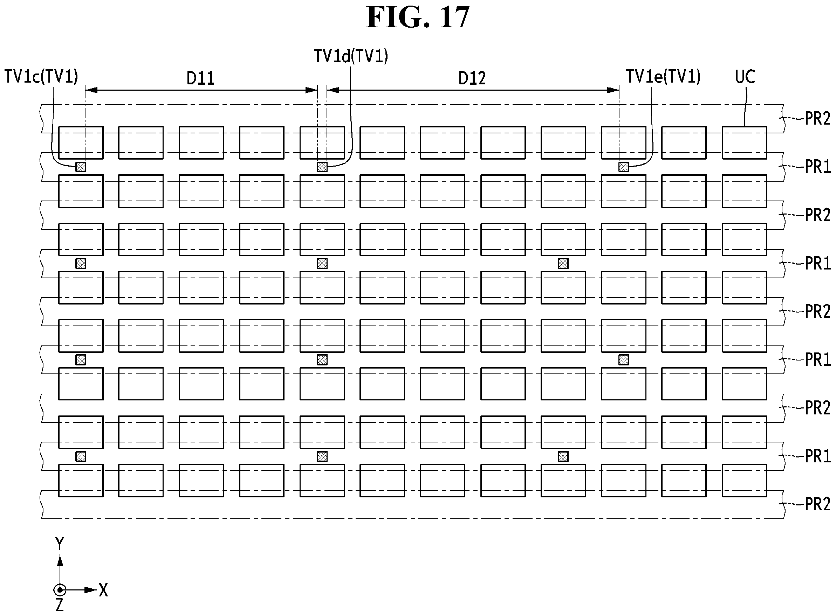

Referring to FIG. 17, in the semiconductor device according to some embodiments, at least some of the plurality of first through-vias TV1 arranged along the first direction X may be spaced apart from each other by different spacings.

For example, the first through-via TV1 may include a third sub-through-via TV1c, a fourth sub-through-via TV1d and a fifth sub-through-via TV1e sequentially arranged in the first direction X. One first power wiring PR1 may be commonly connected to the third sub-through-via TV1c, the fourth sub-through-via TV1d, and the fifth sub-through-via TV1e. The third sub-through-via TV1c and the fourth sub-through-via TV1d may be spaced apart from each other by a first distance D11 in the first direction X. The fourth sub-through-via TV1d and the fifth sub-through-via TV1e may be spaced apart from each other in the first direction X by a second distance D12 that is different from the first distance D11.

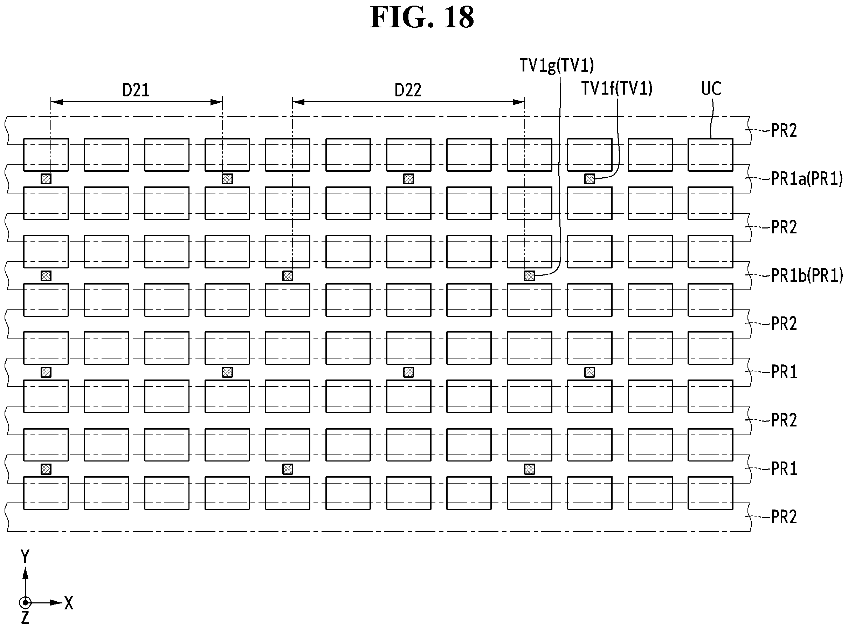

Referring to FIG. 18, in the semiconductor device according to some embodiments, at least some of the plurality of first through-vias TV1 may be spaced apart from each other by different spacing.

For example, the first power wiring PR1 may include a first power line PR1a and a second power line PR1b. The first power line PR1a and the second power line PR1b may be spaced apart from each other in the second direction Y and each thereof may extend in an elongated manner in the first direction X.

The first through-via TV1 may include a plurality of sixth sub-through-vias TV1f and a plurality of seventh sub-through-vias TV1g. The plurality of sixth sub-through-vias TV1f may be arranged along the first direction X and may be spaced apart from each other by a third distance D21. The first power line PR1a may be commonly connected to the plurality of sixth sub-through-vias TV1f. The plurality of seventh sub-through-vias TV1g may be arranged along the first direction X and spaced apart from each other by a fourth distance D22 that is different from the third distance D21. The second power line PR1b may be commonly connected to the plurality of seventh sub-through-vias TV1g.

While the present inventive concept has been particularly shown and described with reference to example embodiments thereof, it will be understood by those of ordinary skill in the art that various changes in form and details may be made therein without departing from the scope of the present inventive concept as defined by the following claims. It is therefore desired that the present embodiments be considered in all respects as illustrative and not restrictive, reference being made to the appended claims rather than the foregoing description to indicate the scope of the invention.

## Claims

1. A semiconductor device comprising:
a substrate including a first surface and a second surface opposite to each other;
a first active pattern including a first lower active pattern and a first upper active pattern on the first surface, wherein the first lower active pattern and the first upper active pattern extend in a first direction;
a second active pattern including a second lower active pattern and a second upper active pattern on the first surface, wherein the second lower active pattern and the second upper active pattern extend in the first direction;
a first gate structure that extends in a second direction that intersects the first direction on the first active pattern;
a second gate structure that extends in the second direction on the second active pattern, wherein the first gate structure and the second gate structure are aligned along the second direction;
a cutting structure between the first active pattern and the second active pattern, wherein the cutting structure extends in the first direction and separates the first gate structure and the second gate structure;
a front wiring pattern that extends in the first direction on an upper surface of the cutting structure;
a first back wiring pattern that extends in the first direction on the second surface; and
a first through-via that extends into the substrate and into the cutting structure, wherein the first through-via electrically connects the front wiring pattern and the first back wiring pattern.

2. The semiconductor device of claim 1, wherein a width in the second direction of the first through-via is less than a width in the second direction of the cutting structure.

3. The semiconductor device of claim 1 or claim 2, further comprising:
an upper connection contact electrically connected to an upper source/drain area of the first upper active pattern on a side surface of the first gate structure,
wherein the first through-via and the upper connection contact are aligned with each other along the second direction.

4. The semiconductor device of any preceding claim, further comprising:
a first upper connection contact on a side surface of the first gate structure,
wherein the first upper connection contact electrically connects a first upper source/drain area of the first upper active pattern and the front wiring pattern.

5. The semiconductor device of claim 4, wherein the first through-via does not overlap the first upper connection contact in the second direction.

6. The semiconductor device of claim 4 or claim 5, further comprising:
a second upper connection contact on a side surface of the second gate structure,
wherein the second upper connection contact electrically connects a second upper source/drain area of the second upper active pattern and the front wiring pattern.

7. The semiconductor device of any preceding claim, further comprising:
a second back wiring pattern that extends in the first direction on the second surface,
wherein the first back wiring pattern and the second back wiring pattern are aligned along the second direction, and
wherein the first back wiring pattern and the second back wiring pattern are configured to receive different power voltages.

8. The semiconductor device of claim 7, further comprising:
a lower connection contact on a side surface of the first gate structure,
wherein the lower connection contact electrically connects a lower source/drain area of the first lower active pattern and the second back wiring pattern.

9. The semiconductor device of any preceding claim, further comprising:
an upper connection contact on a side surface of the first gate structure, wherein the upper connection contact is electrically connected to an upper source/drain area of the first upper active pattern;
a lower connection contact on a side surface of the first gate structure, wherein the lower connection contact is electrically connected to a lower source/drain area of the first lower active pattern; and
a second through-via that extends into the substrate and into the cutting structure, wherein the second through-via electrically connects the upper connection contact and the lower connection contact.

10. The semiconductor device of claim 9, wherein the first through-via and the second through-via are aligned along the first direction.

11. A semiconductor device comprising:
a substrate including a first surface and a second surface opposite to each other;
a lower active pattern that extends in a first direction on the first surface;
an upper active pattern that extends in the first direction on the first surface, wherein the upper active pattern is a first distance from the first surface that is greater than a second distance from the lower active pattern to the first surface;
a gate structure on the lower active pattern and the upper active pattern, wherein the gate structure extends in a second direction that intersects the first direction;
a first cutting structure spaced apart from the lower active pattern and the upper active pattern in the second direction, wherein the first cutting structure extends in the first direction and intersects the gate structure;
a first front wiring pattern that extends in the first direction on an upper surface of the first cutting structure;
a first upper connection contact on a side surface of the gate structure, wherein the first upper connection contact is electrically connected to an upper source/drain area of the upper active pattern;
a first back wiring pattern that extends in the first direction on the second surface;
a first lower connection contact on a side surface of the gate structure, wherein the first lower connection contact is electrically connected to a lower source/drain area of the lower active pattern;
a first through-via that extends into the substrate and into the first cutting structure, wherein the first through-via electrically connects the first front wiring pattern and the first back wiring pattern; and
a second through-via that extends into the substrate and into the first cutting structure, wherein the second through-via electrically connects the first upper connection contact and the first lower connection contact,
wherein the first through-via and the second through-via are aligned along the first direction.

12. The semiconductor device of claim 11, wherein each of a width in the second direction of the first through-via and a width in the second direction of the second through-via is less than a width in the second direction of the first cutting structure.

13. The semiconductor device of claim 11 or claim 12, further comprising:
a second back wiring pattern that extends in the first direction on the second surface,
wherein the first back wiring pattern and the second back wiring pattern are aligned along the second direction, and
wherein the first back wiring pattern and the second back wiring pattern are configured to receive different power voltages.

14. The semiconductor device of claim 13, further comprising:
a second upper connection contact on a side surface of the gate structure, wherein the second upper connection contact electrically connects the upper source/drain area and the first front wiring pattern; and
a second lower connection contact on a side surface of the gate structure, wherein the second lower connection contact electrically connects the lower source/drain area and the second back wiring pattern.

15. The semiconductor device of any of claims 11-14, wherein the upper source/drain area includes n-type impurities, and
wherein the lower source/drain area includes p-type impurities.
